# FASCICULE DE BREVET EUROPEEN

(11) **EP 3 375 266 B1**
(45) Date de publication et mention de la délivrance du brevet: **30.03.2022**
(21) Numéro de dépôt: 16805312.2
(22) Date de dépôt: 11.11.2016
(51) Int. Cl.: H05K 7/14

(54) **BARRE DE CONNEXION ELECTRIQUE**
ELEKTRISCHE SAMMELSCHIENE
ELECTRICAL BUSBAR

(30) Priorité: 13.11.2015 FR 1560865
(43) Date de publication de la demande: 19.09.2018
(73) Titulaire: Valeo Siemens eAutomotive France SAS, 95800 Cergy (FR)
(72) Inventeur: SANVITO, Guillaume, 78990 Elancourt (FR); SMAL, Pierre, 78500 Sartrouville (FR)
(74) Mandataire: Novembre, Christophe Adelphe
(86) Numéro de dépôt international: PCT/EP2016/077421
(87) Numéro de publication internationale: WO 2017/081245

(56) Documents cités:
- EP-A1- 2 736 160
- EP-A1- 2 811 576
- EP-A2- 2 328 392
- DE-A1-102011 080 912
- US-A- 4 677 540
- US-A- 5 579 217

## Description

La présente invention concerne une barre de connexion électrique et un équipement électrique comprenant une barre de connexion électrique selon l'invention, notamment pour des applications dans le domaine de l'automobile.

On connait un onduleur pour commander une machine électrique embarquée dans un véhicule. La machine embarquée dans le véhicule permet notamment d'entrainer les roues du véhicule. Un tel onduleur peut comprendre un module électronique de puissance comprenant des composants par lesquels passe l'énergie alimentant la machine électrique ; et une unité électronique de contrôle comprenant des composants pour contrôler les composants de l'unité électronique de puissance.

Par exemple, la publication de demande de brevet Européen EP2736160 décrit un onduleur logé dans un boitier et embarqué dans un véhicule. Le document divulgue une barre de connexion électrique qui réalise la connexion électrique entre un module de puissance de l'onduleur et un connecteur électrique monté dans une paroi du boitier. Le connecteur électrique réalise une connexion électrique avec la machine électrique commandée par l'onduleur. L'encombrement du boitier doit être la plus faible possible pour prendre le moins de place dans le véhicule. Il est recherché un agencement des composants qui améliore la densité d'intégration de tous les composants de l'onduleur dans le boitier.

Le document US 5 579 217 A décrit un convertisseur comprenant un ensemble de bus laminé destiné à connecter électriquement un contrôleur de grilles de transistor et des interrupteurs. Ce document divulgue une barre de connexion électrique selon le préambule de la revendication 1.

A cet effet, l'invention propose une barre de connexion électrique destinée à connecter électriquement un composant électrique, ladite barre de connexion électrique comprenant :
- au moins une pièce conductrice électriquement,
- un revêtement en matière électriquement isolante recouvrant ladite pièce au moins dans un plan principal de la barre de connexion,
   la pièce conductrice électriquement comprenant :
   - une première extrémité formant une borne de connexion électrique,
   - une portion plane s'étendant suivant ledit plan principal,
   - un cylindre conducteur électriquement qui s'étend depuis une première face de la portion plane dans une direction transversale par rapport au plan principal, la paroi interne du cylindre s'étendant depuis une ouverture située dans la portion plane de façon à recevoir une tige pour une mise en appui de l'extrémité distale du cylindre sur une borne du composant électrique, le revêtement comprenant au moins une excroissance s'étendant transversalement depuis le plan principal du même côté que le cylindre conducteur électriquement, son extrémité distale étant configurée pour former une surface d'appui de la barre de connexion électrique contre un support.

Ainsi, lorsque la borne du composant électrique est située à une distance par rapport au plan principal de la barre de connexion électrique, le cylindre électriquement conducteur permet de franchir cette distance pour permettre une connexion électrique avec la borne du composant électrique. En recevant une tige pour une mise en appui de l'extrémité distale du cylindre sur la borne du composant électrique, le cylindre assure un contact électrique opérationnel entre la barre de connexion et la borne du composant. On entend par contact électrique opérationnel, un contact électrique permettant à la barre de connexion électrique d'échanger une énergie électrique avec le composant de manière que le composant assure la fonction pour laquelle il est conçu.

Selon un mode de réalisation, le cylindre conducteur électriquement s'étend perpendiculairement depuis le plan principal et l'excroissance s'étend en faisant un angle supérieur à 90° par rapport à la portion de la barre de connexion s'étendant dans le plan principal.

Selon un mode de réalisation, la portion plane de la pièce conductrice électriquement comprend une deuxième face opposée à sa première face et dépourvue de matière électriquement isolante autour de l'ouverture.

Selon un mode de réalisation, la barre de connexion comprend une pluralité de ladite pièce conductrice électriquement, notamment trois.

L'invention concerne également un équipement électrique destiné à être embarqué dans un véhicule, comprenant :
- un boitier,
- au moins un premier composant électrique logé dans ledit boitier,
- un connecteur électrique traversant une ouverture du boitier de manière à permettre un échange d'énergie entre le premier composant et un composant extérieur à l'équipement électrique,
- une barre de connexion électrique selon l'invention dans lequel la première extrémité est connectée à une borne du connecteur électrique, ladite barre étant positionnée de sorte que l'extrémité distale du cylindre conducteur électriquement est en contact avec une borne électrique du premier composant,
- une tige reçue dans le fut du cylindre conducteur électriquement de sorte que l'extrémité distale du cylindre conducteur électriquement vient en appui sur la borne électrique du premier composant électrique, l'extrémité distale de l'excroissance du revêtement venant en appui sur une surface issue du boîtier.

Selon un mode de réalisation, le premier composant électrique est un module électronique de puissance comprenant des interrupteurs destinés à recevoir un courant échangé avec une machine électrique ; l'équipement électrique comprenant en outre une unité électronique de contrôle comportant des composants destinés à commander les composants de l'équipement électrique ; l'unité électronique de contrôle et le module électronique de puissance étant superposés ;
et dans lequel le cylindre conducteur électriquement traverse l'unité électronique de contrôle à travers une ouverture pour venir en contact avec la borne électrique du module de puissance.

Selon un mode de réalisation, le module électronique de puissance est positionné sur une paroi du boitier, l'unité électronique de contrôle est supportée par une paroi située entre l'unité électronique de contrôle et le module électronique de puissance, ladite paroi comportant un trou pour le passage du cylindre conducteur électriquement.

Selon un mode de réalisation, l'unité électronique de contrôle comporte un capteur de courant configuré pour mesurer un courant circulant par l'intermédiaire de la barre de connexion, ledit capteur de courant comprenant une ouverture entourant le cylindre conducteur électriquement de manière à mesurer ledit courant, notamment en mesurant un champ magnétique induit par le passage du courant.

L'invention va être décrite en détail dans la description qui suit en liaison avec les dessins ci-annexés. Il est à noter que ces dessins n'ont d'autre but que d'illustrer le texte de la description et ne constituent en aucune sorte une limitation de la portée de l'invention.
Les figures 1 et 2 sont des vues en perspective d'un exemple d'équipement électrique 1 selon l'invention.
Les figures 3 et 4 sont respectivement des vues d'un premier logement et d'un deuxième logement de l'équipement électrique lorsque les couvercles sont enlevés.
La figure 5 est une vue en coupe de l'équipement électrique.
Les figures 6 et 7 sont d'autres vues du premier logement de l'équipement électrique avec certains composants enlevés.
Les figures 8 et 9 sont des vues en coupe de l'ensemble formant boitier de l'équipement électrique.
Les figures 10 et 11 sont des vues en perspective du premier boitier de l'ensemble.
La figure 12 représente un joint d'étanchéité inséré entre le premier et le deuxième boitier de l'ensemble.
Les figures 13 et 14 sont des vues en perspective du deuxième boitier de l'ensemble.
La figure 15 en une vue de détail illustrant un exemple de barre de connexion électrique selon l'invention lorsqu'il est montée dans le premier boitier.
Les figures 16 et 17 sont des vues en perspective de l'exemple de barre de connexion électrique selon l'invention.
La figure 18 est une vue en perspective de l'exemple de barre de connexion électrique selon l'invention sans son revêtement.

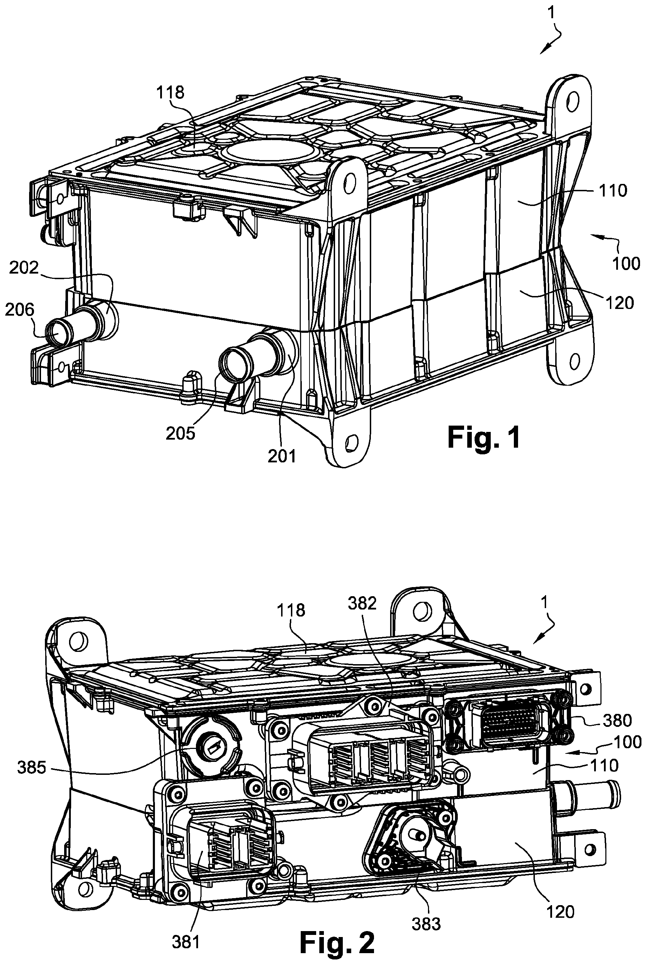

Les figures 1 et 2 montrent des vues en perspective d'un exemple d'équipement électrique 1 qui comprend une barre de connexion électrique selon l'invention. L'équipement électrique comprend un ensemble 100 qui loge les composants de l'équipement électrique 1. L'équipement électrique 1 comprend notamment un onduleur destiné à alimenter une machine électrique telle qu'une machine électrique tournante, par exemple une machine destinée à entrainer les roues d'un véhicule, à partir d'un premier réseau électrique du véhicule. L'équipement électrique comprend notamment un convertisseur DC/DC destiné à convertir une tension entre le premier réseau électrique continu et un deuxième réseau électrique continu du véhicule. L'onduleur et le convertisseur DC/DC peuvent être intégrés tous les deux dans l'équipement électrique 1, ce qui permet de gagner en densité d'intégration dans le véhicule. Par exemple, le premier réseau électrique est un réseau haute tension et le deuxième réseau électrique est un réseau basse tension. Typiquement, un réseau basse tension délivre une tension inférieure à 60V, notamment de 18 ou 12V environ ; un réseau haute tension délivre une tension supérieure à 60V, notamment supérieure à 100, 200, voire 400V.

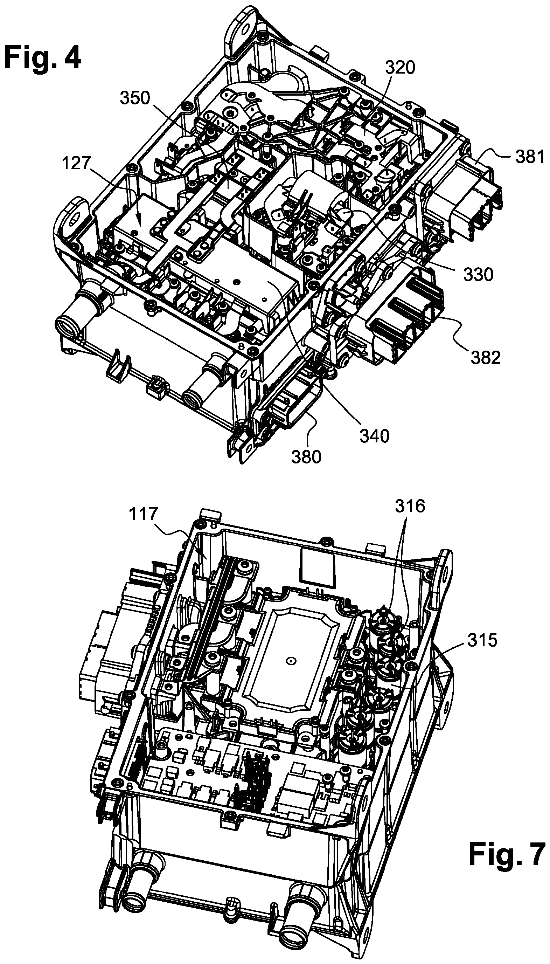

La figure 7 montre l'intégration d'une barre de connexion électrique 400 selon l'invention dans un boitier 110 de l'équipement électrique 1. Certains composants ne sont pas représentés pour faciliter la compréhension.

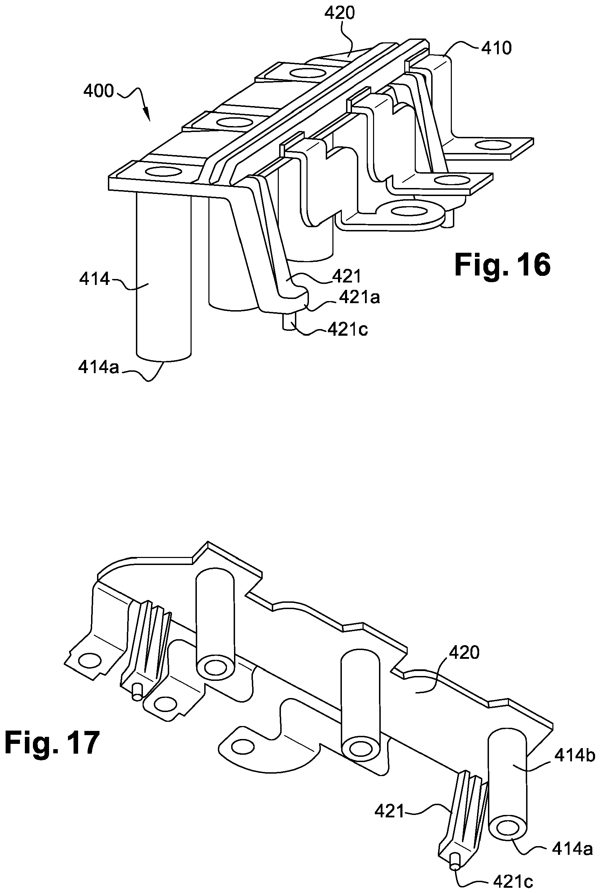

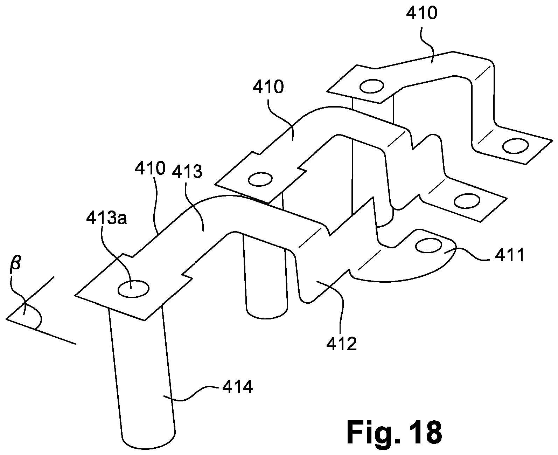

La barre de connexion 400 réalise une connexion électrique avec un premier composant 300, En particulier, la barre de connexion électrique 400 connecte le premier composant 300 avec un connecteur électrique 382. Le connecteur électrique 382 traverse une ouverture du boitier 110 pour permettre un échange d'énergie électrique entre le premier composant 300 et l'extérieur de l'équipement électrique 1, notamment avec les phases de la machine électrique commandée par l'onduleur. Les figures 16 à 18 montrent des vues en perspective de la barre de connexion 400.

La barre de connexion électrique comprend trois pièces 410 conductrices électriquement. Notamment, chaque pièce 410 conductrice électriquement permet de connecter électriquement une phase de la machine électrique commandée par l'onduleur avec le premier composant 300. La barre de connexion 400 pourrait comprendre un nombre pièces 410 différent, notamment un nombre fonction du nombre de phases de la machine électrique commandée par le premier composant 300. Chaque pièce conductrice 410 est notamment une pièce d'un seul tenant. Les pièces 410 conductrices électriquement sont par exemple en cuivre.

Un revêtement 420 recouvre les pièces conductrices 410 de matière isolante électriquement. Notamment, la matière isolante est une matière plastique surmoulée sur les pièces conductrices 410. Le revêtement 420 recouvre les pièces conductrices 410 dans un plan β dans lequel s'étend une portion plane 413 de la pièce conductrice 410. Une première extrémité 411 de la pièce conductrice 410 forme une borne de connexion électrique de la pièce conductrice 410. La première extrémité 411 vient en contact avec une borne 382e du connecteur électrique 382. Un contact mécanique est par exemple obtenu par une vis, par soudage ou tout autre moyen.

Notamment, la première extrémité 411 est reliée à la portion plane 413 par une portion intermédiaire 412. La permet de franchir une distance entre la portion plane 413 et la première extrémité 411. Notamment la première extrémité 411 est positionnée pour correspondre avec une borne 382e du connecteur électrique 382. La portion intermédiaire 412 peut s'étendre suivant une direction transversale par rapport au plan β ou dans une direction parallèle au plan β pour permettre un contact avec la borne 382e du connecteur électrique 382.

La première extrémité 411, la portion intermédiaire 412 et la portion plane 413 sont notamment d'un seul tenant. Elles peuvent être formées à partir d'une seule lame, notamment une lame métallique.

La partie plane 413 comprend une ouverture 413a. Un cylindre 414 en matériau électriquement conducteur s'étend depuis l'ouverture 413a à partir d'une première face de la pièce conductrice 410 dans une direction transversale par rapport au plan principale β. Le cylindre 414 est par exemple en cuivre. En particulier, le cylindre 414 est rapporté sur la partie plane 413. Le cylindre 414 est notamment solidarisé avec la partie plane 413 par une soudure laser ou avec une colle par exemple. Le cylindre 414 et la partie plane 413 pourraient être solidarisés d'une autre façon, pourvu qu'il y ait un contact électrique opérationnel entre la barre de connexion 400 et le premier composant 300. Alternativement, le cylindre 414 et la partie plane 413 pourraient être obtenus ensemble en conformant un même matériau.

Notamment, l'extrémité proximale 414b du cylindre 414 correspond avec l'ouverture 413a de la partie plane 413. En particulier, la paroi interne du cylindre 414 au niveau de l'extrémité proximale vient en correspondance avec les bords du de l'ouverture 413a de la partie plane 413. Le cylindre 414 est donc creux et forme notamment un fût dans lequel peut s'introduire une tige 500 par l'ouverture 413a de la portion plane 413.

Lorsqu'il est monté dans l'équipement électrique 1, le cylindre 414 reçoit la tige 500 qui vient mettre en appui l'extrémité distale 414a du cylindre 414 contre une borne électrique 300e du premier composant 300.

L'extrémité distale 414a du cylindre 414 forme donc une borne de connexion électrique de la barre de connexion 400. Le cylindre 414a déporte la borne électrique de la barre de connexion 400 depuis le plan principal β pour la mettre à un plan distant du plan principal β. Ainsi, le plan principal β de la barre de connexion peut être à un niveau différent du plan dans lequel se trouve la borne électrique 300e du premier composant 300, ce qui d'améliorer l'intégration des composants dans le boitier 110 de l'équipement électrique 1. En mettant en appui l'extrémité distale 414a du cylindre 414 avec la borne électrique 300e du premier composant 300, la tige 500 assure un bon contact électrique entre l'extrémité distale 414a du cylindre 414 et la borne électrique 300e du premier composant 300.

En particulier, le revêtement 420 laisse à nue une partie de la portion plane 413 en périphérie immédiate de l'ouverture 413a de la portion plane 413. Une deuxième face la portion plane 413 qui est opposée à la première face est donc dépourvue de matière électriquement isolante autour de l'ouverture 413a. Ainsi, une tête 500a de la tige 500 peut venir exercer un effort directement sur la surface de la pièce conductrice 410 et pas sur le revêtement 420, ce qui améliore la tenue dans le temps de la mise en appui du cylindre 414 sur la borne 300e du premier composant 300.

La tige 500 peut être en matière électriquement conductrice, telle qu'un métal comme l'acier. En venant directement en contact avec la surface de la pièce conductrice 410, la tête 500a peut permettre une circulation d'un courant par l'intermédiaire de la tige 500 qui contribue à l'échange de courant entre la barre de connexion 400 et le premier composant 300.

Pour réaliser la mise en appui du cylindre 414 sur la borne électrique 300e du premier composant 300, la tige 500 peut comprendre un filetage qui correspond avec un filetage correspondant dans la paroi interne du cylindre 414 et avec un filetage correspondant dans un trou de la borne 300e du premier composant 300. Une rondelle peut être insérée entre la tête 500a de la tige 500. Cependant, la mise en appui pourrait être obtenue autrement ; par exemple avec une technique pressfit. En outre, en venant en prise avec la borne électrique 300e du premier composant 300, et notamment avec la paroi interne du cylindre 414, la tige 500 contribue au maintien mécanique de la barre de connexion dans l'équipement électrique.

Le revêtement 420 peut comprendre des excroissances 421 qui contribuent au maintien mécanique de la barre de connexion électrique 400, en particulier dans le boitier 110 de l'équipement électrique 1. L'excroissance 421 s'étend transversalement depuis le plan principal β du même côté que le cylindre 414. En particulier l'excroissance 421 forme une patte dont l'extrémité distale 421a vient en appui contre un support S. En particulier, le support S est une portion de matière du boitier 110 de l'équipement électrique 1. L'extrémité distale 421a forme donc une surface qui vient en appui sur le support S pour contribuer au maintien mécanique de la barre de connexion 400 dans le boitier 110. En particulier, l'excroissance 421 s'étend depuis la partie du revêtement 420 qui est dans le plan principal, en s'éloignant du cylindre 414. Cela améliore la stabilité de la barre de connexion 400 dans l'équipement électrique.

L'extrémité distale 421a de l'excroissance 421 peut comprendre un pion 421c qui vient dans un trou du support S pour une indexation en position de la barre de connexion 400 lors de son montage dans le boitier 110. Notamment, la barre de connexion 400 est introduite suivant une direction dans le boitier 110 par une ouverture définie par des parois latérales 116 du boitier 110. En particulier, le pion 421c coopère avec le trou du support S pour bloquer la barre de connexion 400 suivant des directions transverses par rapport à la direction d'introduction, mais pas suivant la direction d'introduction, de manière à s'assurer qu'une mise en appui est obtenue entre l'extrémité distale 414a du cylindre 414 et la borne 300e du premier composant 300.

En particulier, le cylindre 414 s'étend perpendiculairement depuis le plan principal β. La direction du cylindre 414 correspond notamment à la direction d'introduction de la barre de connexion électrique 400 pour être positionné dans l'équipement électrique 1.

Le premier composant 300 est notamment un module électronique de puissance 300 faisant partie de l'onduleur. En particulier, le module électronique de puissance 300 comporte des composants destinés à alimenter la machine électrique. Le module électronique désigne un ensemble de composants, notamment des interrupteurs électroniques, tels que des transistors semiconducteurs, qui sont montés dans un boitier propre au module 300 et accessibles électriquement depuis l'extérieur du boitier propre au module 300 par les bornes électriques 300e du module électronique 300. Les interrupteurs sont notamment agencés en circuit électrique pour permettre un passage commandé d'énergie électrique entre une source d'alimentation électrique, notamment le premier réseau électrique du véhicule, et un composant extérieur, notamment la machine électrique commandée par l'onduleur. Ce module électronique de puissance 300 peut être supporté par une première paroi 111 du boiter 110, qui forme notamment un fond du boitier 110

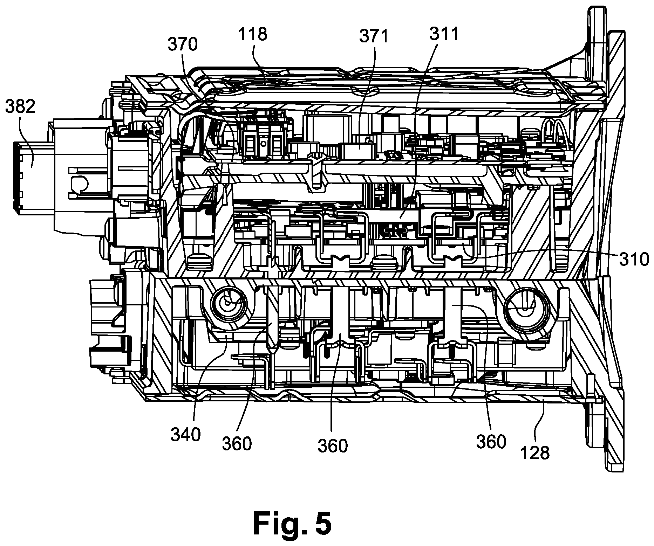

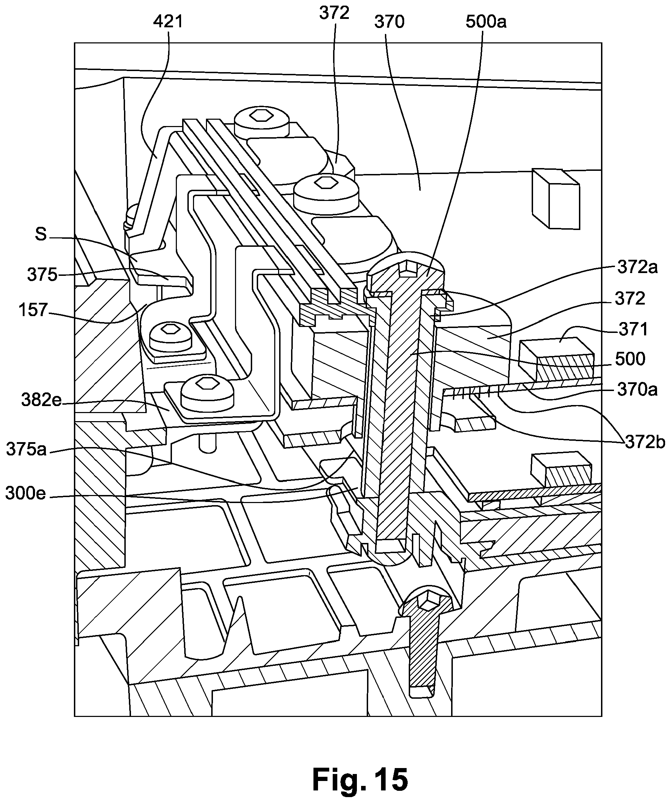

Une unité électronique de contrôle 370 et un support 375 de l'unité électronique de contrôle 370 sont par exemple logés dans le même boitier 110, comme illustré en figure 5 et 15. Le support 375 de l'unité électronique de contrôle 370 est une paroi, notamment une plaque, qui est suspendue dans le logement 117 défini par le boitier 110. Par exemple, le support est rapporté dans le boitier 110 et maintenu en place en venant en appui contre des portions de matière du premier boitier 110, notamment des excroissances 157 issues de la surface du boitier 110. Le support 375 est notamment maintenu en place en venant en appui au niveau de sa périphérie. Le support 375 est par exemple en métal pour améliorer la dissipation thermique de l'unité électronique de contrôle 370. L'unité électronique de contrôle 370 est notamment une carte électronique 370 sur laquelle des composants 371 sont montés. L'unité électronique de contrôle 370 est supportée par le support 375 par l'intermédiaire d'une face en contact avec le support 375. En particulier, l'unité électronique de contrôle 370 contrôle les composants de l'onduleur et/ou du convertisseur DC/DC, notamment les interrupteurs du module électronique de puissance 300. A cet effet, l'unité électronique 370 peut échanger un signal de données avec l'extérieur de l'équipement électrique, par exemple avec un clntrôleur du véhicule.

En particulier, le module de puissance 300, le support 375 de l'unité électronique de contrôle 370 et l'unité électronique de contrôle 370 sont superposés l'un en vis-à-vis de l'autre dans le premier logement 117 défini par le premier boitier 110. Le support 375 de l'unité électronique de contrôle se trouve entre le module de puissance 300 et l'unité électronique de contrôle 370.

Lorsque la barre de connexion 400 est montée dans l'équipement électrique 1, le cylindre 414 traverse l'unité électronique de contrôle 370 à travers une ouverture 370a et traverse le support 375 de l'unité électronique de contrôle 370 à travers une ouverture 375a pour venir en contact avec la borne électrique 300e du module électronique de puissance 300. Cet agencement permet de gagner de la place dans le boitier 117 et améliore ainsi l'intégration des composants dans le logement 117 défini par le boitier 110.

En outre, l'unité électronique de contrôle 370 peut comprendre des capteurs de courant 372 pour mesurer les courants circulant par la barre de connexion 400. Les capteurs de courant 372 sont notamment montés en surface de la carte électronique formant l'unité électronique de contrôle 370. En particulier, l'unité électronique de contrôle 370 comprend un capteur de courant 372 respectif pour deux des pièces conductrices 410 et pas pour la troisième pièce conductrice 410. Le courant circulant la troisième pièce conductrice 410 peut être déduit à partir des courants mesurés sur les deux autres pièces conductrices. Chaque capteur de courant 372 comporte une ouverture 372a traversée par le cylindre 414. Notamment, le capteur de courant 372 mesure le courant à partir d'un champ magnétique induit par le passage du courant. Les capteurs de courants 372 sont par exemple des capteurs à effet hall. Chaque capteur de courant 372 peut comprendre des broches 372b qui sont reçues dans la carte électronique formant l'unité électronique de contrôle 370 pour y acheminer la valeur du courant mesuré.

Le boitier 110, désigné ci-après premier boitier 110, peut être associé avec un deuxième boitier 120 pour former un ensemble 100 formant boitier de l'équipement électrique 1.

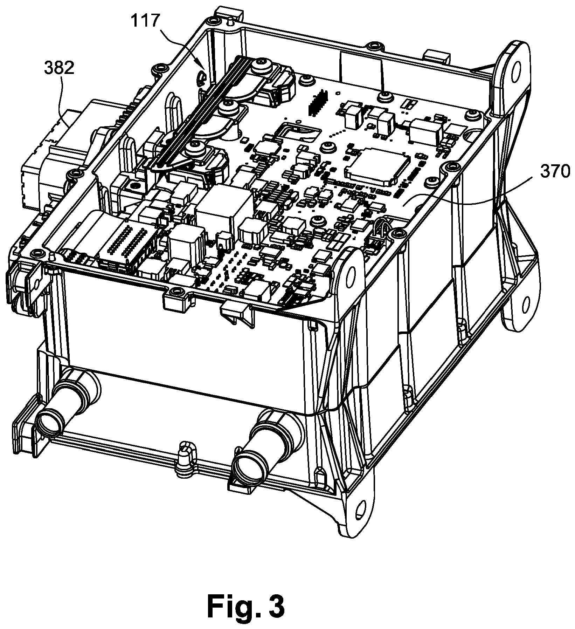

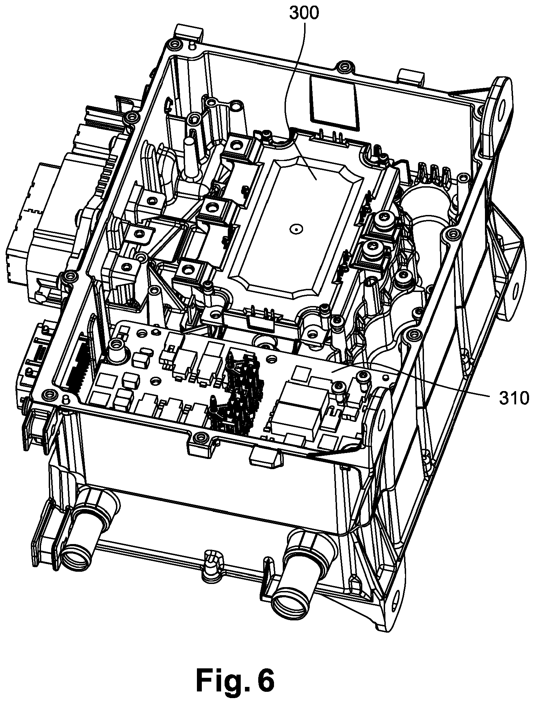

Outre, le module électronique de puissance 300, l'unité électronique de contrôle 370 et le support 375 de l'unité électronique de contrôle, le premier boitier 110 peut recevoir d'autres premiers composants, illustrés par exemple en figures 3 et 5 à 7. Le deuxième boitier 120 reçoit un ou des deuxièmes composants électriques, illustrés par exemple en figures 4 et 5.

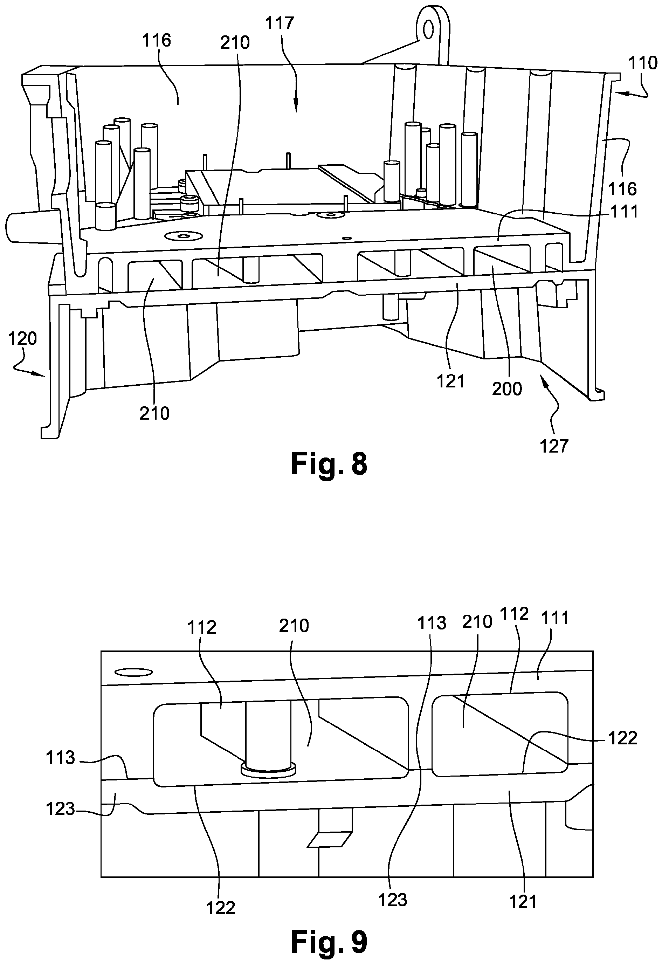

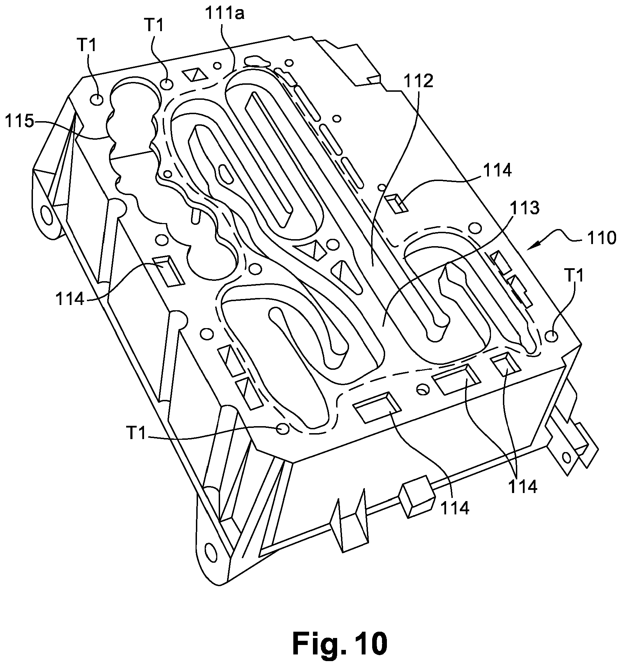

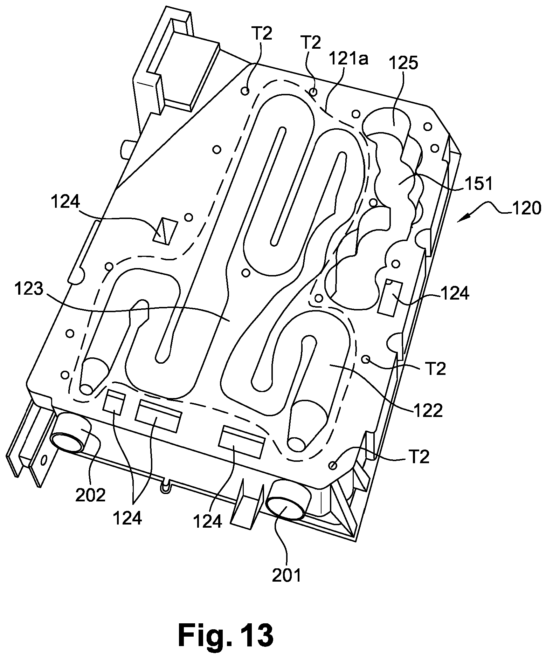

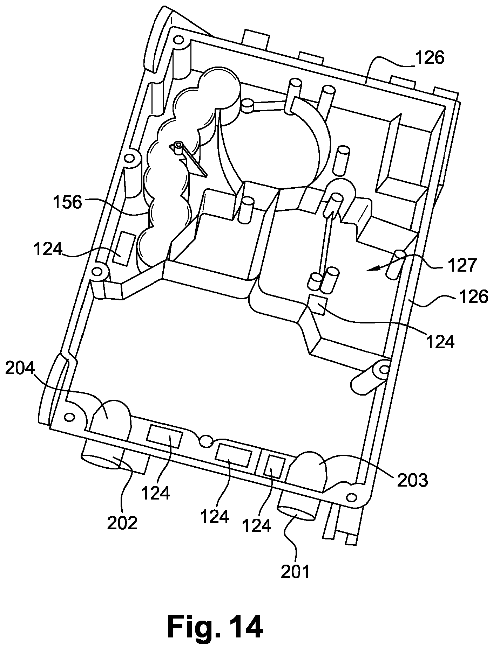

Des exemples de premier 110 et deuxième 120 boitier sont illustrés en figures 8 à 14. Le premier boîtier 110 peut comprendre une première paroi 111 qui vient en appui avec une deuxième paroi 121 du deuxième boitier 120 pour former un circuit de refroidissement 200 de l'équipement électrique 1. A cet effet, la première paroi 111 peut comprendre une gorge 112 qui vient en vis-à-vis avec une gorge 122 de la deuxième paroi 120 pour former le circuit de refroidissement 200. Le circuit de refroidissement 200 reçoit un fluide destiné à refroidir l'équipement électrique 1.

En particulier, la première gorge 112 et la deuxième gorge 122 viennent en vis-à-vis pour former un canal 210 du circuit de refroidissement dans lequel va circuler le fluide de refroidissement. Ainsi, le diamètre du canal de refroidissement est réparti entre les deux parois.

En particulier, la première paroi 111 et la deuxième paroi 121 viennent l'une contre l'autre au niveau de surfaces sensiblement planes respectives 113, 123, dites surfaces d'appui. La surface d'appui 113 de la première paroi 111 comprend les bords de la première gorge 112 ; et la surface d'appui 123 de la deuxième paroi 121 comprend les bords de la deuxième gorge 122. On entend par bord de la première 112 ou de la deuxième 122 gorge, la frontière entre la gorge 112, 122 et la surface depuis laquelle la gorge 112,122 se creuse. La surface depuis laquelle la première gorge 112 se creuse correspond notamment à la surface d'appui 113 de la première paroi 111 ; et la surface depuis laquelle la deuxième gorge 122 se creuse correspond notamment à la surface d'appui 123 de la deuxième paroi 121. En particulier, les bords de la première 112 ou deuxième 122 gorges sont intégralement compris dans leur surface d'appui 113, 123 respective.

En prévoyant des surfaces d'appui planes entre la première 111 et la deuxième paroi 121, on facilite la mise en œuvre de l'étanchéité du circuit de refroidissement 200. En effet, les parties de la première paroi 111 et de le deuxième paroi 121 qui viennent l'une contre l'autre pour former le circuit de refroidissement 200 sont de préférence usinées pour éliminer des irrégularités de surface qui pourraient créer des espaces de fuite du fluide de refroidissement hors du circuit de refroidissement 200. En prévoyant des surfaces de contact 113, 123 planes on facilite l'usinage de ces surfaces d'appui 113, 123.

La première paroi 111 peut comprendre au moins un trou traversant 114 et la deuxième paroi 121 peut comprendre au moins un trou traversant 124, dont les bords viennent en contact l'un sur l'autre pour former un passage entre la face de la première paroi 111 qui est opposée à la face portant la première gorge 112 et la face de la deuxième paroi 121 qui est opposée à la face portant la deuxième gorge 122. En particulier, ces trous traversants 114, 124 forment un passage entre le premier logement 117 défini par le premier boitier 110 et un deuxième logement 127 défini par le deuxième boitier 120. Ces trous traversants 114, 124, sont notamment formés à l'extérieur des zones 111a, 121a des première 111 et deuxième 121 parois qui forment le circuit de refroidissement 200.

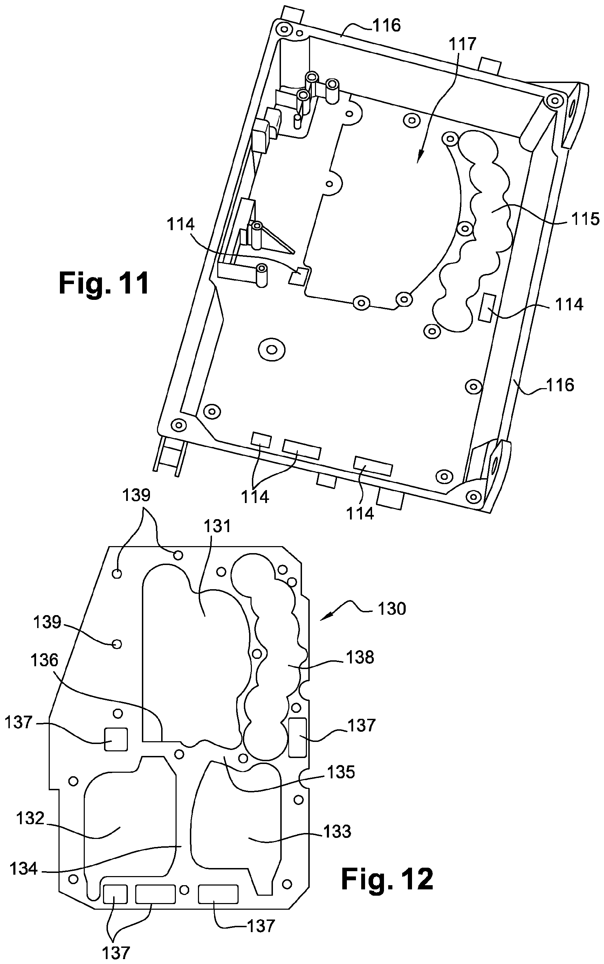

Un joint d'étanchéité peut être positionné entre la première paroi 111 et la deuxième paroi 121. Un exemple de joint d'étanchéité 130 est illustré en figure 12. Le joint d'étanchéité 130 réalise en particulier une étanchéité autour des zones 111a, 121a des première 111 et deuxième 121 parois qui forment le circuit de refroidissement 200. A cet effet, le joint d'étanchéité 130 vient notamment entre les surfaces d'appui 113, 123 de la première paroi 111 et de la deuxième paroi 121. Le joint d'étanchéité 130 peut être dépourvu de matière dans une partie qui se situe dans le circuit de refroidissement 200 lorsqu'il est formé à l'exception de bandes de matière 134, 135,136. Ces bandes de matière 134, 135, 136 améliorent la rigidité du joint d'étanchéité 130 de manière à faciliter la manutention et le placement du joint d'étanchéité 130. Ces bandes de matière 134, 135,136 peuvent avoir des largeurs juste suffisantes pour obtenir une rigidité et définissent des ouvertures 131, 132, 133. Le joint d'étanchéité 130 réalise une étanchéité le long d'une ligne fermée autour du circuit de refroidissement 200, notamment autour des zones 111a, 121a des parois 111, 121 qui forment le circuit de refroidissement 200. Le joint d'étanchéité 130 peut également réaliser l'étanchéité autour des passages formés dans la première paroi 111 et la deuxième paroi 121. Le joint d'étanchéité 130 comprend alors des trous 137 dont les bords réalisent l'étanchéité autour desdits passages. Le joint d'étanchéité 130 peut aussi comprendre des trous 139 qui permettent le passage d'organes de fixation respectifs pour la fixation de la première paroi 111 sur la deuxième paroi 121.

Le circuit de refroidissement 200 peut comprendre un port d'entrée 201 et un port de sortie 202 par lesquels le fluide de refroidissement entre et sort du circuit de refroidissement 200. Les ports d'entrée 201 et de sortie 202 sont compris dans le deuxième boitier 120, en particulier dans une paroi latérale 126 du deuxième boitier 120 décrite ci-après. Notamment, les ports d'entrée/sortie 201, 202 sont des ouvertures tubulaires dans la paroi latérale 116. Ces ports d'entrées/sorties 201,202 sont prolongés par des tubes 203, 204 qui communiquent avec la deuxième gorge 122 de la deuxième paroi 121 pour y acheminer ou y extraire le fluide de refroidissement. Des embouts 205, 206 peuvent être insérés dans les ports d'entrée/sortie 201, 202 pour les adapter à un circuit d'alimentation en fluide de refroidissement.

Chaque boitier 110, 120 peut comprendre des parois latérales respectives 116, 126 qui s'étendent transversalement depuis la périphérie de la première 111 ou de la deuxième 121 paroi de manière à définir un premier logement 117 et un deuxième logement 127 respectifs. En particulier, lorsque les premier 110 et deuxième 120 boitiers sont montés l'un sur l'autre de manière à former le circuit de refroidissement 200, les parois latérales 116 du premier boitier 110 s'étendent dans une direction opposée par rapport au deuxième boitier 120 et les parois latérales 126 du deuxième boitier 120 s'étendent dans une direction opposée par rapport au premier boitier 110. Chaque logement 117, 127 peut être fermé par un couvercle respectif 118, 128 qui vient contre les extrémités distales des dites parois latérales 116, 126. Ainsi, la première paroi 111 forme un fond du premier boitier 110 et la deuxième paroi 121 forme un fond du deuxième boitier 120.

Notamment, le premier boitier 110 et le deuxième boitier 120 sont fixés l'un à l'autre par des organes de fixation qui maintiennent la première paroi 111 en appui contre la deuxième paroi 121. Ces organes de fixation sont par exemple des vis s'introduisant dans des trous correspondants T1, T2 dans la première paroi 111 et la deuxième paroi 121. Les organes de fixation peuvent être aussi des clips, par exemple portés par les parois latérales 116,126 du premier boitier 110 et du deuxième boiter 120.

Le premier logement 117 défini par le premier boitier 110 peut comprendre une carte électronique à substrat métallique isolée (SMI ou « Insulated Molded Substrate » en anglais) 310 faisant parti du convertisseur DC/DC. La carte SMI porte notamment des composants pour la conversion de tension entre le premier et le deuxième réseau électrique du véhicule. La carte SMI 310 peut être supportée par la première paroi 111 du premier boitier 110, avec une de ses faces venant en contact avec la première paroi 111. La carte SMI comprend par exemple des interrupteurs électroniques, tels que des transistors semiconducteurs, ou autres.

Le deuxième logement 127 défini par le deuxième boitier 120 peut recevoir un filtre de compatibilité électromagnétique (ou EMC) 320 pour filtrer un signal d'entrée de l'équipement électrique 1, et/ou un filtre EMC 330 pour filtrer un signal de sortie de l'équipement électrique 1, et/ou un composant magnétique 340 comportant une inductance pour la rectification d'un courant délivré au module de puissance 300 et un transformateur pour le convertisseur DC/DC de l'équipement électrique 1 et/ou un module capacitif 350 destiné à permettre un commutation à zéro de tension (ou ZVS) des commutateurs électriques compris dans le module électronique 300 et/ou sur la carte SMI 310. Ces deuxièmes composants 320, 330, 340, 350 peuvent être supportés par la deuxième paroi 121, avec une de leur face venant en contact avec la deuxième paroi 121.

La première paroi 111 peut comprendre une ouverture traversante 115 dont les bords viennent en correspondance avec une ouverture 125 de la deuxième paroi 120. Une excroissance 156 s'étend depuis les bords de l'ouverture 125 sur la face de la paroi 121 qui est opposée à la face de la paroi 121 qui porte la deuxième gorge 122. L'excroissance forme une cavité 151 qui reçoit un bloc capacitif 315, visible en figure 7. Le bloc capacitif 315 comprend plusieurs condensateurs 316. Il est connecté à l'onduleur, notamment au module électronique de puissance 300, et au convertisseur DC/DC, notamment à la carte SMI 310. En particulier, le bloc capacitif 315 est dans la liaison électrique entre le premier réseau électrique du véhicule et le module électronique de puissance 300 et la carte SMI 310 ; et constitue une réserve d'énergie au plus proche du module électronique de puissance 300 et la carte SMI 310, notamment pour un découpage par leurs interrupteurs. A cet effet, le bloc capacitif 315 est connecté au module de puissance 300 et à la carte SMI par une barre de connexion électrique (non représentée). L'ouverture traversante 115 de la première paroi 111 est à l'extérieur de la zone 111a de la première paroi 111 qui est destinée à former le circuit de refroidissement 200. L'ouverture 125 de la deuxième paroi 121 est à l'extérieur de la zone 121a de la deuxième paroi 121 qui est destiné à former le circuit de refroidissement 200. Le joint d'étanchéité comprend un trou 138 pour permettre le passage du bloc capacitif 315.

Les composants logés dans le premier logement 117 peuvent être reliés électriquement avec les deuxièmes composants 320, 330, 340, 350 par l'intermédiaire des passages définis par les trous traversants 114, 124 formés dans la première 111 et la deuxième paroi 121. La figure 5 illustre un exemple de connexion électrique entre un connecteur électrique 311 de la carte SMI 310 et une borne du composant magnétique 340 par l'intermédiaire d'un connecteur électrique 360.

En particulier, les interrupteurs électroniques de l'onduleur et du convertisseur DC/DC de l'équipement électrique 1, notamment le module électronique de puissance 300 et la carte SMI 310, sont logés dans l'un des deux boitiers 110, 120 alors que les composants de filtrage et de redressement 320, 330, 340, 350 de l'équipement électrique 1 sont logés dans l'autre des deux boitiers. Cela permet de partager les composants de filtrage entre l'onduleur et le convertisseur DC/DC. En outre, en logeant les interrupteurs, notamment le module électronique de puissance 300 et la carte SMI 310, dans un même boitier, il est plus facile de les contrôler avec une seule unité électronique de contrôle 370. Une telle unité électronique de contrôle 370 est par exemple logée dans le même boitier que les interrupteurs, comme illustré en figure 5.

Outre le connecteur électrique 382 faisant notamment la connexion électrique entre le module électronique de puissance 300 et les phases de la machine électrique, l'équipement électrique 1 peut comprendre un connecteur signal 380 destiné à permettre un échange de signal de données entre les composants de l'équipement électrique 1 et l'extérieur de l'équipement électrique, par exemple avec un contrôleur du véhicule. En particulier, le connecteur signal 380 est connecté à l'unité électronique de contrôle 370. L'équipement électrique 1 peut comprendre un connecteur d'entrée de puissance 381 qui permet l'alimentation électrique des composants de l'équipement électrique 1. En particulier, le connecteur d'entrée de puissance 381 permet une connexion électrique avec le premier réseau électrique du véhicule, notamment avec une unité de stockage électrique de ce premier réseau électrique, pour fournir une énergie électrique en entrée de l'onduleur et/ou du convertisseur DC/DC de l'équipement électrique 1. Un connecteur électrique de sortie DC/DC 383 peut permettre de transférer une énergie électrique entre le convertisseur DC/DC de l'équipement électrique 1 et le deuxième réseau électrique du véhicule, notamment avec une unité de stockage électrique de ce deuxième réseau électrique. Ces connecteurs électriques 380, 381, 382, 383 sont notamment sur un côté de l'ensemble 100 formant boitier de l'équipement électrique 1 illustré en figure 2. En particulier, ces connecteurs électriques 380, 381, 382, 383 sont sur des parois latérales 116, 126 du premier 110 et du deuxième 120 boitiers.

L'équipement électrique 1 peut comprendre un évent 385 pour contrôler l'humidité à l'intérieur de l'équipement électrique 1. L'évent 385 est notamment porté un côté de l'ensemble 100 formant boitier de l'équipement électrique 1. Par exemple, il est porté sur une paroi latérale 116 du premier boitier 110. Il pourrait aussi être porté sur une paroi latérale 126 du deuxième boitier 126.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuventêtre indépendantes entre elles d'un mode à l'autre, ou combinées entre elles, comme cela ressort des revendications.

Notamment, la barre de connexion électrique 410 a été décrite avec trois pièces 410 conductrices électriquement, mais elle pourrait comprendre un nombre différent de trois. La barre de connexion électrique pourrait faire la liaison électrique avec un composant autre que le module de puissance 300. L'équipement électrique 1 pourrait se passer de la plaque formant support 375 de l'unité électronique de contrôle 370. L'unité électronique de contrôle pourrait alors être supportée par le boîtier 110, notamment par des surfaces issues du boitier 110.

## Revendications

1. Barre de connexion électrique (400) destinée à connecter électriquement un composant électrique (300), ladite barre de connexion électrique (400) comprenant :
- au moins une pièce conductrice électriquement (410),
- un revêtement (420) en matière électriquement isolante recouvrant ladite pièce (410) au moins dans un plan principal (β) de la barre de connexion (400),
la pièce conductrice électriquement (410) comprenant :
- une première extrémité (411) formant une borne de connexion électrique,
- une portion plane (413) s'étendant suivant ledit plan principal (β),
- un cylindre conducteur électriquement (414) qui s'étend depuis une première face de la portion plane (413) dans une direction transversale par rapport au plan principal (β), la paroi interne du cylindre s'étendant depuis une ouverture (413a) située dans la portion plane (413) de façon à recevoir une tige (500) pour une mise en appui de l'extrémité distale (414a) du cylindre (414) sur une borne (300e) du composant électrique (300); **caractérisée en ce que** le revêtement (420) comprend au moins une excroissance (421) s'étendant transversalement depuis le plan principal (β) du même côté que le cylindre conducteur électriquement (414), son extrémité distale (421a) étant configurée pour former une surface d'appui de la barre de connexion électrique (400) contre un support (S).

2. Barre de connexion électrique (400) selon la revendication précédente, dans lequel le cylindre conducteur électriquement (414) s'étend perpendiculairement depuis le plan principal (β) et l'excroissance (421) s'étend en faisant un angle supérieur à 90° par rapport à la portion de la barre de connexion (400) s'étendant dans le plan principal (β).

3. Barre de connexion électrique (400) selon l'une des revendications précédentes, dans lequel la portion plane (413) de la pièce conductrice électriquement (410) comprend une deuxième face opposée à sa première face et dépourvue de matière électriquement isolante autour de l'ouverture (413a).

4. Barre de connexion électrique (400) selon l'une des revendications précédentes, comprenant une pluralité de ladite pièce conductrice électriquement (410), notamment trois.

5. Equipement électrique (1) destiné à être embarqué dans un véhicule, comprenant :
- un boitier (110),
- au moins un premier composant électrique (300) logé dans ledit boitier (110),
- un connecteur électrique (382) traversant une ouverture du boitier (110) de manière à permettre un échange d'énergie entre le premier composant (300) et un composant extérieur à l'équipement électrique (1),
- une barre de connexion électrique (400) selon l'une des revendications précédentes dans lequel la première extrémité (411) est connectée à une borne (382e) du connecteur électrique (382), ladite barre (400) étant positionnée de sorte que l'extrémité distale (414a) du cylindre conducteur électriquement (414) est en contact avec une borne électrique (300e) du premier composant (300),
- une tige (500) reçue dans le fut du cylindre conducteur électriquement (414) de sorte que l'extrémité distale (414a) du cylindre conducteur électriquement (414) vient en appui sur la borne électrique (300e) du premier composant électrique (300).

6. Equipement électrique (1) selon la revendication 5, comprenant une barre de connexion (400) selon la revendication 1 ou 2, et dans lequel l'extrémité distale (421a) de l'excroissance (421) du revêtement (420) vient en appui sur une surface (S) issue du boîtier (110).

7. Equipement électrique (1) selon la revendication 5 ou 6, dans lequel le premier composant électrique (300) est un module électronique de puissance comprenant des interrupteurs destinés à recevoir un courant échangé avec une machine électrique; l'équipement électrique (1) comprenant en outre une unité électronique de contrôle (370) comportant des composants (371) destinés à commander les composants de l'équipement électrique (1) ; l'unité électronique de contrôle (370) et le module électronique de puissance (300) étant superposés ;
et dans lequel le cylindre conducteur électriquement (414) traverse l'unité électronique de contrôle (370) à travers une ouverture (370a) pour venir en contact avec la borne électrique (300e) du module de puissance (300).

8. Equipement électrique (1) selon la revendication 7, dans lequel le module électronique de puissance (300) est positionné sur une paroi du boitier (110), l'unité électronique de contrôle (370) est supportée par une paroi (375) située entre l'unité électronique de contrôle (370) et le module électronique de puissance (300), ladite paroi (375) comportant un trou (375a) pour le passage du cylindre conducteur électriquement (414).

9. Equipement électrique (1) selon l'une des revendications 5 à 8, dans lequel l'unité électronique de contrôle (370) comporte un capteur de courant (372) configuré pour mesurer un courant circulant par l'intermédiaire de la barre de connexion (400), ledit capteur de courant (372) comprenant une ouverture (372a) entourant le cylindre conducteur électriquement (414) de manière à mesurer ledit courant, notamment en mesurant un champ magnétique induit par le passage du courant.

## Patentansprüche

1. Elektrische Sammelschiene (400) zur elektrischen Verbindung eines elektrischen Bauelements (300), wobei die elektrische Sammelschiene (400) Folgendes umfasst:
- mindestens ein elektrisch leitendes Teil (410),
- eine Abdeckung (420) aus elektrisch isolierendem Material, die das Teil (410) wenigstens in einer Hauptebene (β) der Sammelschiene (400) abdeckt, wobei das elektrisch leitende Teil (410) Folgendes umfasst:
- ein erstes Ende (411), das eine elektrische Anschlussklemme bildet,
- einen ebenen Abschnitt (413), der sich entlang der Hauptebene (β) erstreckt,
- einen elektrisch leitenden Zylinder (414), der sich von einer ersten Seite des ebenen Abschnitts (413) in einer Richtung quer zur Hauptebene (β) erstreckt, wobei sich die Innenwand des Zylinders von einer Öffnung (413a) erstreckt, die sich so in dem ebenen Abschnitt (413) befindet, dass sie einen Stift (500) für ein Inanlagebringen des distalen Endes (414a) des Zylinders (414) auf einer Klemme (300e) des elektrischen Bauelements (300) aufnimmt; **dadurch gekennzeichnet, dass** die Abdeckung (420) wenigstens eine Ausstülpung (421) umfasst, die sich von der Hauptebene (β) auf derselben Seite wie der elektrisch leitende Zylinder (414) quer erstreckt, wobei ihr distales Ende (421a) dazu ausgebildet ist, eine Anlagefläche der elektrischen Sammelschiene (400) gegen einen Halter (S) zu bilden.

2. Elektrische Sammelschiene (400) nach dem vorhergehenden Anspruch, wobei sich der elektrisch leitende Zylinder (414) von der Hauptebene (β) senkrecht erstreckt und sich die Ausstülpung (421) in einem Winkel größer als 90° zu dem Abschnitt der Sammelschiene (400) erstreckt, der sich in der Hauptebene (β) erstreckt.

3. Elektrische Sammelschiene (400) nach einem der vorhergehenden Ansprüche, wobei der ebene Abschnitt (413) des elektrisch leitenden Teils (410) eine zweite Seite umfasst, die seiner ersten Seite gegenüberliegt und kein elektrisch isolierendes Material um die Öffnung (413a) herum aufweist.

4. Elektrische Sammelschiene (400) nach einem der vorhergehenden Ansprüche, umfassend eine Mehrzahl des elektrisch leitenden Teils (410), insbesondere drei.

5. Elektrische Ausrüstung (1) zum Einbau in ein Fahrzeug, umfassend:
- ein Gehäuse (110),
- wenigstens ein erstes elektrisches Bauelement (300), das in dem Gehäuse (110) untergebracht ist,
- einen elektrischen Verbinder (382), der so durch eine Öffnung des Gehäuses (110) hindurchtritt, dass ein Energieaustausch zwischen dem ersten Bauelement (300) und einem Bauelement außerhalb der elektrischen Ausrüstung (1) gestattet wird,
- eine elektrische Sammelschiene (400) nach einem der vorhergehenden Ansprüche, wobei das erste Ende (411) mit einer Klemme (382e) des elektrischen Verbinders (382) verbunden ist, wobei die Schiene (400) so positioniert ist, dass das distale Ende (414a) des elektrisch leitenden Zylinders (414) mit einer elektrischen Klemme (300e) des ersten Bauelements (300) in Kontakt steht,
- einen Stift (500), der im Schaft des elektrisch leitenden Zylinders (414) so aufgenommen ist, dass das distale Ende (414a) des elektrisch leitenden Zylinders (414) auf der elektrischen Klemme (300e) des ersten elektrischen Bauelements (300) zur Anlage kommt.

6. Elektrische Ausrüstung (1) nach Anspruch 5, umfassend eine Sammelschiene (400) nach Anspruch 1 oder 2 und wobei das distale Ende (421a) der Ausstülpung (421) der Abdeckung (420) auf einer Fläche (S) aus dem Gehäuse (110) zur Anlage kommt.

7. Elektrische Ausrüstung (1) nach Anspruch 5 oder 6, wobei das erste elektrische Bauelement (300) ein Leistungselektronikmodul ist, das Schalter umfasst, die dazu bestimmt sind, einen Strom aufzunehmen, der mit einer elektrischen Maschine ausgetauscht wird; wobei die elektrische Ausrüstung (1) ferner eine elektronische Steuereinheit (370) umfasst, die Bauelemente (371) aufweist, die dazu bestimmt sind, die Bauelemente der elektrischen Ausrüstung (1) zu steuern; wobei die elektronische Steuereinheit (370) und das Leistungselektronikmodul (300) übereinander gelagert sind;
und wobei der elektrisch leitende Zylinder (414) durch eine Öffnung (370a) durch die elektronische Steuereinheit (370) hindurchtritt, um mit der elektrischen Klemme (300e) des Leistungsmoduls (300) in Kontakt zu treten.

8. Elektrische Ausrüstung (1) nach Anspruch 7, wobei das Leistungselektronikmodul (300) auf einer Wand des Gehäuses (110) positioniert ist, die elektronische Steuereinheit (370) von einer Wand (375) getragen wird, die sich zwischen der elektronischen Steuereinheit (370) und dem Leistungselektronikmodul (300) befindet, wobei die Wand (375) ein Loch (375a) für den Durchtritt des elektrisch leitenden Zylinders (414) aufweist.

9. Elektrische Ausrüstung (1) nach einem der Ansprüche 5 bis 8, wobei die elektronische Steuereinheit (370) einen Stromsensor (372) aufweist, der dazu ausgebildet ist, einen Strom zu messen, der durch die Sammelschiene (400) strömt, wobei der Stromsensor (372) eine Öffnung (372a) umfasst, die den elektrisch leitenden Zylinder (414) umgibt, um den Strom zu messen, insbesondere durch Messung eines Magnetfelds, das durch den Stromfluss induziert wird.

## Claims

1. Electrical busbar (400) intended to electrically connect an electrical component (300), said electrical busbar (400) comprising:
- at least one electrically conductive part (410),
- a coating (420) of electrically insulating material covering said part (410) at least in a main plane (β) of the busbar (400),
the electrically conductive part (410) comprising:
- a first end (411) forming an electrical connection terminal,
- a flat portion (413) extending on said main plane (β),
- an electrically conductive cylinder (414) which extends from a first face of the flat portion (413) in a transverse direction with respect to the main plane (β), the inner wall of the cylinder extending from an aperture (413a) situated in the flat portion (413) so as to receive a rod (500) for making the distal end (414a) of the cylinder (414) bear on a terminal (300e) of the electrical component (300); **characterized in that** the coating (420) comprises at least one protuberance (421) extending transversely from the main plane (β) on the same side as the electrically conductive cylinder (414), its distal end (421a) being configured to form a bearing surface for the electrical busbar (400) to bear against a support (S).

2. Electrical busbar (400) according to the preceding claim, wherein the electrically conductive cylinder (414) extends at right angles from the main plane (β) and the protuberance (421) extends by forming an angle greater than 90° with respect to the portion of the busbar (400) extending in the main plane (β).

3. Electrical busbar (400) according to either of the preceding claims, wherein the flat portion (413) of the electrically conductive part (410) comprises a second face opposite its first face and without any electrically insulating material around the aperture (413a).

4. Electrical busbar (400) according to one of the preceding claims, comprising a plurality of said electrically conductive parts (410), notably three of them.

5. Electrical equipment (1) intended to be embedded in a vehicle, comprising:
- a housing (110),
- at least one first electrical component (300) housed in said housing (110),
- an electrical connector (382) passing through an aperture of the housing (110) so as to allow an exchange of energy between the first component (300) and a component outside the electrical equipment (1),
- an electrical busbar (400) according to one of the preceding claims in which the first end (411) is connected to a terminal (382e) of the electrical connector (382), said bar (400) being positioned such that the distal end (414a) of the electrically conductive cylinder (414) is in contact with an electrical terminal (300e) of the first component (300),
- a rod (500) received in the shaft of the electrically conductive cylinder (414) such that the distal end (414a) of the electrically conductive cylinder (414) bears on the electrical terminal (300e) of the first electrical component (300).

6. Electrical equipment (1) according to Claim 5, comprising a busbar (400) according to Claim 1 or 2, and wherein the distal end (421a) of the protuberance (421) of the coating (420) comes to bear on a surface (S) derived from the housing (110).

7. Electrical equipment (1) according to Claim 5 or 6, wherein the first electrical component (300) is a power electronic module comprising switches intended to receive a current exchanged with an electrical machine; the electrical equipment (1) further comprising a control electronic unit (370) comprising components (371) intended to control the components of the electrical equipment (1); the control electronic unit (370) and the power electronic module (300) being superposed;
and wherein the electrically conductive cylinder (414) passes through the control electronic unit (370) through an aperture (370a) to come into contact with the electrical terminal (300e) of the power module (300).

8. Electrical equipment (1) according to Claim 7, wherein the power electronic module (300) is positioned on a wall of the housing (110), the control electronic unit (370) is supported by a wall (375) situated between the control electronic unit (370) and the power electronic module (300), said wall (375) comprising a hole (375a) for the passage of the electrically conductive cylinder (414).

9. Electrical equipment (1) according to one of Claims 5 to 8, wherein the control electronic unit (370) comprises a current sensor (372) configured to measure a current circulating via the busbar (400), said current sensor (372) comprising an aperture (372a) surrounding the electrically conductive cylinder (414) so as to measure said current, notably by measuring a magnetic field induced by the passage of the current.
